(19) Europäisches Patentamt / European Patent Office / Office européen des brevets

(11) **EP 2 423 173 B1**

(12) **FASCICULE DE BREVET EUROPEEN**

(45) Date de publication et mention
de la délivrance du brevet:
**13.03.2019 Bulletin 2019/11**

(51) Int Cl.:
***B60Q 3/00*** *(2017.01)*

(21) Numéro de dépôt: **11187878.1**

(22) Date de dépôt: **13.11.2007**

(54) **STRUCTURE FEUILLETEE LUMINEUSE AVEC COUCHE POREUSE**

LAMINIERTES BELEUCHTUNGSSTRUKTUR MIT PORÖSE SCHICHT

LAMINATED LIGHTING STRUCTURE WITH A POROUS LAYER

(84) Etats contractants désignés:
**AT BE BG CH CY CZ DE DK EE ES FI FR GB GR
HU IE IS IT LI LT LU LV MC MT NL PL PT RO SE
SI SK TR**

(30) Priorité: **14.11.2006 FR 0654886**

(43) Date de publication de la demande:
**29.02.2012 Bulletin 2012/09**

(62) Numéro(s) de document de la (des) demande(s)
initiale(s) en application de l'article 76 CBE:
**07858693.0 / 2 089 331**

(73) Titulaire: **Saint-Gobain Glass France
92400 Courbevoie (FR)**

(72) Inventeurs:
• **Huignard, Arnaud
60200 COMPIEGNE (FR)**
• **Rohaut, Nathalie
95390 SAINT-PRIX (FR)**
• **Besson, Sophie
60200 COMPIEGNE (FR)**

(74) Mandataire: **Saint-Gobain Recherche
Département Propriété Industrielle
39 Quai Lucien Lefranc
93300 Aubervilliers (FR)**

(56) Documents cités:
WO-A-2006/103575     WO-A-2007/077099
WO-A-2008/059171     FR-A- 2 809 496

**Description**

La présente invention se rapporte au domaine des matériaux poreux et notamment à l'utilisation d'une couche poreuse .

On connaît déjà des couches poreuses essentiellement minérales obtenues par voie sol-gel. Le document EP1329433 divulgue ainsi une couche poreuse élaborée à partir d'un sol de tétraéthoxysilane (TEOS) hydrolysé en milieu acide avec un agent porogène à base de polyéthylène glycol tert phényle éther (dit Triton) à une concentration entre 5 et 50 g/l. La combustion de cet agent porogène à 500°C libère les pores. Appliquée sur un substrat en verre, cette couche est un antireflet servant pour des vitrines ou pour améliorer l'efficacité de cellules solaires.

L'invention propose une structure feuilletée lumineuse qui comporte :

- un premier substrat transparent et plan, d'indice optique n1 donné, notamment un verre clair ou extraclair voire un plastique
- un deuxième substrat plan teinté dans la masse, notamment un verre teinté,
- un intercalaire de feuilletage, entre les premier et deuxième substrats,
- une couche poreuse formant séparateur optique, déposée sur l'intercalaire de feuilletage ou sur le premier substrat, la couche étant d'indice optique n2, l'écart n1 - n2 étant supérieur ou égal à 0,1, voire 0,2, et par exemple jusqu'à 0,4, de préférence dans toute la gamme du visible
- une source lumineuse couplée à la tranche du premier substrat, notamment des diodes électroluminescentes (« led » en anglais),
- un réseau rétrodiffusant interne entre la couche poreuse et le premier substrat, et/ou un réseau diffusant externe sur la face externe du premier substrat.

La couche poreuse formant séparateur optique renvoie les rayons lumineux dans le premier substrat transparent formant guide optique.

L'épaisseur de la couche poreuse peut être de préférence supérieure ou égale 200 nm, voire 400 nm et de préférence inférieure à 1 $\mu$m.

Par exemple on choisit pour la couche poreuse un indice de 1, 4 à 1,1 notamment pour un premier substrat verre d'indice 1,5.

En cas de réseau rétrodiffusant interne, cette couche poreuse peut être déposée uniquement entre le réseau interne ou bien recouvrir également le réseau interne.

Le réseau interne est rétrodiffusant, de préférence de facteur de réflexion diffuse supérieur ou égal à 50%, voire à 80%.

Le réseau externe est diffusant, sert pour extraire la lumière, et de préférence de facteur de transmission diffuse supérieur ou égal à 50%, voire à 80%.

Le réseau diffusant ou rétrodiffusant peut être formé de motifs diffusants par exemple de largeur (moyenne) de 0,2 mm à 2 mm, préférentiellement inférieure à 1 mm et d'épaisseur micronique par exemple de 5 à 10 $\mu$m. L'espacement (moyen) entre les motifs peut être 0,2 à 5 mm. Pour former un réseau on peut texturer une couche.

Le réseau diffusant ou rétrodiffusant peut être de préférence essentiellement minéral, à base de liant minéral et/ou de particules diffusantes minérales.

A titre d'exemple de réseau rétrodiffusant on peut choisir une couche diffusante telle que décrite dans la demande de brevet français publiée FR 2 809 496

Le deuxième substrat teinté peut préserver par exemple de la chaleur venant du soleil. On peut garder une certaine transparence pour une vision de l'extérieur par exemple pour les toits de véhicule de transport maritime, terrestre (automobile, véhicules industriels...).

On choisit par exemple les verres dénommés VG10 ou VG40, de la gamme VENUS vendus par la société SAINT GOBAIN GLASS.

Le verre VENUS VG10 a les caractéristiques suivantes : $T_L$ entre 10 et 15%, TE entre 8 et 12,5% (selon la norme TE-PM2) en fonction des épaisseurs. Le verre VENUS VG40 a les caractéristiques suivantes : $T_L$ entre 35 et 42%, TE entre 22 et 28% (selon la norme TE-PM2) en fonction des épaisseurs.

Pour une application bâtiment, on peut par exemple utiliser des verres teintés dans la masse bronze, gris ou vert de la gamme PARSOL vendus par la société SAINT GOBAIN GLASS. Par exemple, le verre PARSOL GRIS a les caractéristiques suivantes : $T_L$ entre 26 et 55% (selon Illuminant D65), TE entre 29 et 57% (selon la norme PM2) en fonction des épaisseurs.

L'éclairage peut être décoratif, d'ambiance, coloré ou non. L'éclairage peut être homogène ou non, en fonction de applications visées (vitrage à logo, signalétique, décor...).

Dans la structure feuilletée lumineuse, l'intercalaire revêtu ou, de préférence, le premier substrat revêtu peut être le substrat revêtu de la couche poreuse déjà décrite précédemment.

La structure feuilletée éclairante, peut être tout particulièrement un toit lumineux, une porte d'un véhicule, un double vitrage lumineux notamment pour le bâtiment, l'extérieur et l'intérieur tels que des façades, cloisons, portes, fenêtres, table ou étagère.

Dans ces exemples de structures feuilletées, la couche poreuse formant séparateur optique peut être formée suivant différentes techniques de l'art antérieur.

Dans un premier mode de réalisation, les pores sont les interstices d'un empilement non compact des billes nanométriques, notamment de silice, cette couche étant décrite par exemple dans le document US20040258929.

Dans un deuxième mode de réalisation, la couche poreuse est obtenue par le dépôt d'un sol de silice condensé (oligomères de silice) et densifié par des vapeurs de type NH3, cette couche étant décrite par exemple dans le document WO2005049757.

Dans un troisième mode de réalisation, la couche poreuse peut aussi être de type sol gel telle que comme décrite dans le document EP1329433. La couche poreuse peut aussi être obtenue avec d'autres agents porogènes connus : des micelles de molécules tensioactives cationiques en solution et, éventuellement, sous forme hydrolysée, ou de tensioactifs anioniques, non ioniques, ou des molécules amphiphiles, par exemple des copolymères blocs.

Comme un intercalaire de feuilletage, on peut choisir notamment une feuille de matière thermoplastique par exemple en polyuréthane (PU), en polyvinylbutyral (PVB), en éthylène vinylacétate (EVA), ou être en résine pluri ou mono-composants réticulable thermiquement (époxy, PU) ou aux ultraviolets (époxy, résine acrylique).

Dans un quatrième mode de réalisation, la couche poreuse est essentiellement minérale de type sol-gel, la couche présentant des pores fermés avec une plus petite dimension caractéristique qui est, en moyenne, supérieure ou égale à 20 nm, de préférence supérieure ou égale à 40 nm tout en restant préférentiellement submicronique en fonction des fonctionnalités et/ou applications visées.

Par ailleurs lorsque le substrat porteur de cette couche poreuse selon le quatrième mode est un vitrage, le vitrage revêtu peut être traité thermiquement, à une température supérieure ou égale à 350°C de préférence supérieure ou égale à 500 voire à 600°C, pour une opération de (bombage) trempe. Il s'agit ainsi de préférence d'un verre trempé.

En effet, cette couche poreuse selon le quatrième mode a la capacité de supporter les traitements thermiques à haute température sans se fissurer et sans altération notable de ses propriétés optiques de sa durabilité ou de sa tenue hydrolytique. Il devient ainsi avantageux de pouvoir déposer la couche poreuse avant le traitement thermique du verre, notamment la trempe et le bombage/formage typiquement entre 500°C et 700°C, sans que cela pose de problème, car il est plus simple sur le plan industriel de faire le dépôt avant tout traitement thermique. On peut ainsi avoir une seule configuration d'antireflet, que le verre porteur soit ou non destiné à subir un traitement thermique.

Il n'est pas nécessaire d'effectuer auparavant un traitement thermique à plus basse température, typiquement entre 350°C et 450°C, pour densifier la couche selon le quatrième mode et supprimer éventuellement l'agent porogène. La densification/formation de cette dernière couche poreuse peut ainsi se faire pendant la trempe ou le bombage.

D'une part, pour la couche poreuse selon le quatrième mode la demanderesse a constaté que des pores de grande taille étaient moins sensibles à l'eau et aux pollutions organiques susceptibles de dégrader ses propriétés notamment optiques (transmission et réflexion lumineuse, indice de réfraction ...). Cela est d'autant plus important pour des façades ou des cellules solaires, constamment exposées aux aléas climatiques.

D'autre part, l'obtention de pores de taille (dimensions(s) caractéristique(s)) et/ou de forme bien définie(s) et susceptibles d'être répartis dans l'espace selon une répartition souhaitée représente un enjeu capital dans les domaines notamment de l'optoélectronique, de l'optique non linéaire. La tortuosité des pores de la couche poreuse selon le quatrième mode est faible.

La régularité dans la formation des pores est importante pour des applications où l'on recherche la production d'un effet ou d'une propriété homogène sur la surface du substrat, en particulier lorsque la propriété est liée à la quantité de matière, la taille, la forme d'une particule ou l'agencement de celles-ci, ce qui est le cas notamment des propriétés optiques (antireflet, indice de réfraction adapté...).

La couche poreuse selon le quatrième mode peut ainsi présenter tout particulièrement une répartition sensiblement homogène dans toute son épaisseur, depuis l'interface avec le substrat ou avec une sous-couche éventuelle jusqu'à l'interface avec l'air ou un autre milieu. La répartition homogène peut être tout particulièrement utile pour établir des propriétés isotropes de la couche.

Pour la couche poreuse selon le quatrième mode, la plus petite dimension caractéristique des pores (et de préférence la plus grande dimension également) peut être encore plus préférentiellement supérieure ou égale à 30 nm et de préférence inférieure à 100 nm voire à 80 nm. Cela dépend des applications visées, de l'épaisseur de la couche.

Pour la couche poreuse selon le quatrième mode, la porosité peut être en outre monodisperse en taille, la taille des pores étant alors calibrée à une valeur minimale de 20 nm, de préférence 40 nm encore plus préférentiellement 50 nm et de préférence inférieure à 100 nm. Cela dépend des applications visées, de l'épaisseur de la couche.

Pour la couche poreuse selon le quatrième mode, La majorité des pores fermés, (voire entre 80% ou plus), peuvent avoir de préférence une plus petite dimension caractéristique, et de préférence une plus grande dimension également, entre 20 et 80 nm.

Pour la couche poreuse selon le quatrième mode, La proportion en volume de pores peut être comprise entre 10% à 90%, de préférence inférieure ou égale à 80%.

La couche poreuse selon le quatrième mode est mécaniquement stable, elle ne s'effondre pas même pour des fortes concentrations de pores. Les pores peuvent être aisément séparés les uns des autres, bien individualisés. Et la couche poreuse selon l'invention est susceptible d'une cohésion et d'une tenue mécanique excellentes. On préfère tout particulièrement une couche poreuse comportant une phase solide (essentiellement) continue, formant ainsi les murs denses des pores, plutôt qu'une phase solide principalement sous forme de (nano)particules ou de cristallites.

Pour la couche poreuse selon le quatrième mode, les pores peuvent avoir une forme allongée, notamment en grain de riz. Encore plus préférentiellement, les pores peuvent avoir une forme sensiblement sphérique ou ovale. On préfère que la majorité des pores fermés, voire au moins 80% d'entre eux, aient une forme donnée sensiblement identique, notamment allongée, sensiblement sphérique ou ovale.

De nombreux éléments chimiques peuvent être à la base de la couche poreuse selon le quatrième mode,. Elle peut comprendre comme matériau constitutif essentiel au moins un composé de l'un au moins des éléments : Si, Ti, Zr, Al, ou encore W, Sb, Hf, Ta, V, Mg, Mn, Co, Ni, Sn, Zn, Ce. Il peut s'agir notamment d'un oxyde simple ou d'un oxyde mixte de l'un au moins des éléments précités.

De préférence, la couche poreuse selon le quatrième mode, peut être essentiellement à base de silice notamment pour son adhésion et sa compatibilité avec un substrat verrier.

La structuration de la couche en pores est liée à la technique de synthèse de type sol-gel, qui permet de condenser la matière essentiellement minérale (c'est-à-dire minérale ou hybride organique minérale) avec un agent porogène convenablement choisi en particulier de taille(s) et/ou de forme(s) bien définie(s) (allongé, sphérique, ovale etc). Les pores peuvent être de préférence vides ou éventuellement être remplis.

On peut ainsi choisir de la silice élaborée à partir de tétraétoxysilane (TEOS), de silicate de sodium, de lithium ou de potassium ou des matériaux hybrides obtenus à partir de précurseurs de type organosilane dont la formule générale est

$$R2_nSi(OR1)_{4-n}$$

avec n un entier entre 0 et 2, R1 une fonction alkyl de type $C_xH_{2x+1}$, R2 un groupement organique comprenant par exemple une fonction alkyl, époxy, acrylate, méthacrylate, amine, phényle, vinyle. Ces composés hybrides peuvent être utilisés mélangés ou seuls, en solution dans l'eau ou dans un mélange eau/alcool à un pH approprié.

Comme couche hybride, on peut choisir une couche à base de méthyltriéthoxysilane (MTEOS), un organosilane à groupement organique non réactif. Le MTEOS est un organosilane qui possède trois groupements hydrolysables et dont la partie organique est un méthyle, non réactif.

Si l'on souhaite conserver les fonctions organiques, on peut choisir un solvant extracteur ad hoc pour éliminer l'agent porogène choisi organique, par exemple le THF pour le polyméthacrylate de méthyle (PMMA). La couche poreuse selon l'invention peut être susceptible d'être obtenue avec au moins un agent porogène solide. L'agent porogène solide donne la possibilité de faire varier la taille des pores de la couche par un choix judicieux de sa taille.

L'agent porogène non localisé de l'art antérieur est de forme indéterminée et se répand dans la structure de façon incontrôlée. L'agent porogène solide selon l'invention permet quant à lui une meilleure maîtrise de la taille des pores, notamment l'accès à des grandes tailles, une meilleure maîtrise de l'organisation des pores notamment une distribution homogène, ainsi qu'une meilleure maîtrise du taux de pores dans la couche et une meilleure reproductibilité.

L'agent porogène solide pour la couche poreuse selon le quatrième mode, se distingue également d'autres agents porogènes connus tels que des micelles de molécules tensioactives cationiques en solution et, éventuellement, sous forme hydrolysée, ou de tensioactifs anioniques, non ioniques, ou des molécules amphiphiles, par exemple des copolymères blocs. De tels agents génèrent des pores sous forme de canaux de petite largeur ou des pores plus ou moins ronds de petite taille entre 2 et 5 nm.

Toutefois, il peut être utile de cumuler diverses formes et/ou tailles de pores dans une seule couche (mono ou multicouche).

L'agent porogène pour la couche poreuse selon le quatrième mode, peut être de préférence plein voire creux, mono ou multi composant, minéral ou organique ou hybride.

L'agent peut être de préférence sous forme particulaire, de préférence (quasi)sphérique. Les particules peuvent être de préférence bien individualisées, ce qui permet de contrôler aisément la taille des pores. La surface de l'agent porogène peut être indifféremment rugueuse ou lisse.

Comme agent porogène creux, on peut citer en particulier des billes de silice creuses. Comme agent porogène plein, on peut citer des billes polymériques monocomposant ou bicomposant notamment avec un matériau coeur et une coque.

L'agent porogène choisi polymérique peut être préférentiellement éliminé pour obtenir la couche poreuse dont les pores peuvent avoir sensiblement la forme et la taille de cet agent porogène.

L'agent porogène solide, notamment polymérique, peut être disponible sous plusieurs configurations. Il peut être stable en solution, typiquement on utilise une dispersion colloïdale, ou être sous forme d'une poudre redispersable dans un solvant aqueux ou alcool correspondant au solvant utilisé pour former le sol ou à un solvant compatible avec ce solvant.

On peut choisir en particulier un agent porogène en l'un des polymères suivants :

- en polyméthacrylate de méthyle (PMMA),
- en copolymères méthyl (méth)acrylate/acide (méth)acrylique,
- en polymères polycarbonates, polyester, polystyrène, etc

ou d'une combinaison de plusieurs de ces matériaux.

Un autre type d'agent porogène servant pour former la couche poreuse selon le quatrième mode, peut être sous forme de nanogouttes d'un premier liquide, notamment à base d'huile, dispersées dans un deuxième liquide, notamment à base d'eau, le premier liquide et le deuxième liquide étant non miscibles. Il s'agit par exemple d'une nanoémulsion.

Les nanogouttes jouent le rôle d'agent porogène avec une taille est bien définie. Après élimination des nanogouttes, on obtient des pores sphériques sensiblement de la taille des nanogouttes.

Le deuxième liquide, qui peut être de préférence à base d'eau, peut servir à condenser le matériau constitutif de la couche. De manière préférentielle, on peut choisir un sol précurseur du matériau constitutif de la couche compatible avec ce deuxième liquide et incompatible avec le premier liquide pour ne pas déstabiliser la nanoémulsion.

Il peut s'agir en particulier de nanogouttes d'huile dispersées dans un milieu aqueux grâce à un système de tensioactifs qui assure la stabilité. Ces nanogouttes sont généralement fabriquées par fragmentation mécanique d'une phase huileuse dans une phase aqueuse en présence de tensioactifs. La taille souhaitée des nanogouttes peut être obtenue notamment grâce à au moins un passage dans un homogénéiseur haute pression.

On peut notamment choisir les nanoémulsions utilisées dans les domaines de la cosmétique et de la santé, par exemple celles décrites dans la demande de brevet WO0205683.

Les nanogouttes pour la couche poreuse selon le quatrième mode, peuvent contenir au moins une huile choisie de préférence parmi les huiles d'origine animale ou végétale, les huiles minérales, les huiles de synthèse, les huiles de silicone, les hydrocarbures notamment aliphatiques, et leurs mélanges.

On peut sélectionner en particulier les huiles suivantes :

- les huiles paraffines ;
- les huiles végétales hydrocarbonées.

Pour renforcer encore davantage la tenue hydrolytique de la couche poreuse pour la couche poreuse selon le quatrième mode,, on peut aussi choisir de superposer une couche oléophobe et/ou hydrophobe greffée, par exemple à base de l'organosilane fluoré décrit dans les brevets US-A-5 368 892 et US-A-5 389 427, ainsi qu'à base d'alkylsilane(s) fluoré(s) hydrolysable(s) décrit(s) dans la demande de brevet EP692463, notamment un perfluoroalkylsilane de formule : $CF_3$-$(CF_2)_n$-$(CH_2)_m$-$SiX_3$, avec n de 0 à 12, m de 2 à 5, X une fonction hydrolysable par exemple chloré ou alkoxy.

Selon la nature de la surface destinée à être revêtue de la couche selon le quatrième mode,, il peut être recommandé, voire nécessaire, d'interposer une couche de primaire afin de favoriser l'adhésion de la couche à son support et/ou d'obtenir simplement une qualité suffisante de cette adhésion. A cette fin, on dépose sur le substrat, préalablement à sa mise en contact avec la composition contenant le précurseur du matériau constitutif de la couche poreuse, une couche de potentiel isoélectrique supérieur ou égal au pH de ladite composition. On peut choisir notamment une sous-couche primaire du type tétrahalogéno- ou tétraalkoxy-silane, comme indiquée dans la demande de brevet EP0484746.

De préférence, la couche poreuse selon le quatrième mode, est formée avec interposition d'une sous-couche à base de silice ou de dérivés au moins partiellement oxydés du silicium choisi parmi le dioxyde de silicium, des oxydes de silicium sous stoechiométriques, l'oxycarbure, l'oxynitrure ou l'oxycarbonitrure de silicium.

La sous-couche s'avère utile quand la surface sous-jacente est en verre silicosodocalcique car elle joue le rôle de barrière aux alcalins.

La sous-couche s'avère utile quand la surface sous-jacente est en plastique car elle permet de renforcer l'adhésion de la couche poreuse.

Cette sous-couche comprend donc avantageusement Si, O, éventuellement du carbone et de l'azote. Mais elle peut comprendre aussi des matériaux minoritaires par rapport au silicium, par exemple des métaux comme Al, Zn ou Zr. La sous-couche peut être déposée par sol-gel ou par pyrolyse, notamment par pyrolyse en phase gazeuse (CVD). Cette dernière technique permet d'obtenir des couches en $SiO_xC_y$ ou en $SiO_2$ assez aisément, notamment par dépôt directement sur le ruban de verre float dans le cas de substrats verriers. Mais on peut aussi effectuer le dépôt par une technique sous vide, par exemple par pulvérisation cathodique à partir d'une cible de Si (éventuellement dopée) ou d'une cible en sous-oxyde de silicium (en atmosphère réactive oxydante et/ou nitrurante par exemple). Cette sous-couche a de préférence une épaisseur d'au moins 5 nm, notamment une épaisseur comprise entre 10 et 200 nm, par exemple entre 80 et 120 nm.

Le matériau constitutif de la couche peut être préférentiellement choisi pour que celle-ci soit transparente à certaines longueurs d'onde. En outre, la couche peut présenter un indice de réfraction à 600 nm et/ou à 550 nm au moins inférieur de 0,1 à l'indice de réfraction d'une couche de même matière minérale dense (sans pores), encore plus préférentiellement 0,2 ou 0,3. De préférence cet indice de réfraction à 600 nm et/ou à 550 nm peut être inférieur ou égal à 1,3 voire inférieur ou égal à 1,1 voire encore même proche de 1 (par exemple 1,05).

A titre indicatif, à 600 nm, une couche en silice non poreuse a typiquement un indice de réfraction de l'ordre de 1,45, une couche en oxyde de titane a un indice de réfraction de l'ordre de 2, une couche en zircone a un indice de réfraction de l'ordre de 1,7.

On peut ajuster à façon l'indice de réfraction en fonction du volume de pores. On peut utiliser en première approximation la relation suivante pour le calcul de l'indice :

$n=f.n_1+(1-f).n_{pores}$ où f est la fraction volumique du matériau constitutif de la couche et $n_1$ son indice de réfraction et $n_{pores}$ est l'indice des pores généralement égal à 1 s'ils sont vides.

En choisissant de la silice, on peut descendre aisément jusqu'à 1,05 et pour toute épaisseur.

On peut aussi ajuster à façon l'épaisseur de la couche en choisissant le taux de solvant adéquat.

L'indice de réfraction de la couche poreuse selon le quatrième mode, est invariant, peu sensible à l'environnement.

Le matériau constitutif de la couche selon le quatrième mode, peut être préférentiellement la silice, hybride ou minérale, du fait du faible indice de ce matériau comme déjà expliqué. Dans ce cas, la silice peut avantageusement être dopée pour améliorer encore davantage sa tenue hydrolytique dans le cas d'applications où une bonne résistance est nécessaire (façades, extérieurs etc). Les éléments dopants peuvent de préférence être choisis parmi Al, Zr, B, Sn, Zn. Le dopant est introduit pour remplacer les atomes de Si dans un pourcentage molaire pouvant de préférence atteindre 10%, encore plus préférentiellement jusqu'à 5%.

Au sens de l'invention, et en l'absence de précision, on comprend par "couche", soit une couche unique (monocouche) soit une superposition de couches (multicouche).

Dans une conception avantageuse, la couche poreuse selon le quatrième mode, peut être sous forme d'une multicouche poreuse, les couches poreuses de la multicouche ayant des pores de tailles distinctes et/ou en quantités distinctes. On peut préférer notamment fabriquer des couches de plus en plus poreuses avec l'épaisseur donc en s'éloignant du substrat porteur de la multicouche, pour donner un empilement de couches avec un indice de réfraction dans le visible décroissant avec l'épaisseur croissante, ceci pour une fonction antireflet encore améliorée. La multicouche peut avoir de préférence une épaisseur entre 100 et 150 nm, de préférence autour de 120 nm, avec un indice moyen de 1,2 à 1,25. La somme du produit indice par épaisseur de toutes les monocouches peut être égale au produit indice par épaisseur de l'équivalent monocouche.

Dans un premier exemple, pour un substrat d'indice 1,5, la couche poreuse la plus proche du substrat peut avoir un indice de 1,4 (voire être une couche de silice non poreuse) et celle la plus éloignée de 1,1 voire 1,05.

Dans un deuxième exemple, on choisit (partant du substrat) une première couche d'indice n1 égale à 1,35 et une épaisseur de 40 nm $\pm$ 10 nm, une deuxième couche d'indice n2 égale à 1,25 et une épaisseur de 40 nm $\pm$ 10 nm et une troisième et dernière couche d'indice n3 égale à 1,15 et une épaisseur de 40 nm $\pm$ 10 nm.

La couche poreuse peut être continue ou discontinue et occuper sensiblement entièrement la face principale du substrat revêtu.

Par ailleurs, le substrat peut être de préférence un substrat essentiellement transparent, notamment à base de verre et/ou de polymère(s), de plastique.

Le substrat porteur de la couche poreuse selon le quatrième mode, affecte généralement une forme essentiellement plane ou bi-dimensionnelle avec un contour variable, tel que par exemple une plaque ou une galette, mais peut aussi affecter une forme volumique ou tri-dimensionnelle constituée de l'assemblage de surfaces essentiellement planes, par exemple en forme de cube ou parallélépipède, ou non.

Le substrat peut être plan voire courbé, organique ou minéral, notamment en verre sous forme d'une feuille, dalle, tube, fibre ou tissu.

A titre d'exemples de matériaux verriers, on peut citer le verre float (ou verre flotté) de composition sodo-calcique classique, éventuellement durci ou trempé par voie thermique ou chimique, un borosilicate d'aluminium ou de sodium ou toute autre composition.

Le verre peut être coloré, teinté dans la masse ou avec une couche décorative.

Le verre peut être clair, extra-clair, à très faible teneur en oxyde(s) de fer. Il s'agit par exemple des verres commercialisés dans la gamme « DIAMANT » par SAINT-GOBAIN GLASS.

De manière avantageuse, la face principale qui est revêtue de la couche poreuse peut présenter un relief macroscopique en creux ou en reliefs, par exemple des motifs en pyramides, notamment de profondeur allant de l'ordre de fraction(s) du millimètre à quelques millimètres notamment allant de 0,001 mm à 5 mm, par exemple allant de 1 à 5 mm.

De préférence, les motifs sont le plus proche possible les uns des autres, et ont par exemple leurs bases distantes de moins de 1 mm, et de préférence de moins de 0,5 mm, et encore plus préférentiellement sont jointifs.

Les motifs peuvent par exemple avoir la forme de cône ou de pyramide à base polygonale, comme triangulaire ou carrée ou rectangulaire ou hexagonale ou octogonale, lesdits motifs pouvant être convexes, c'est-à-dire venant en excroissance par rapport au plan général de la face texturée, ou être concaves, c'est-à-dire venant en creux dans la masse de la plaque.

Pour le cas où les motifs ont la forme de cône ou de pyramide, on préfère que tout demi-angle au sommet dudit cône ou de ladite pyramide soit inférieur à 70°, et de préférence soit inférieur à 60°, par exemple aille de 25° à 50°.

On peut choisir par exemple des verres plans imprimés texturés tels que les verres commercialisés dans la gamme « ALBARINO » par SAINT-GOBAIN GLASS.

Un substrat transparent avec une face ainsi texturée et revêtue cumule les effets :

- le piégeage de la lumière comme montré dans la demande de brevet WO2003/046617 incorporée par référence, demande qui décrit par exemple une plaque texturée présentant à sa surface un ensemble de motifs concaves alignés et totalement jointifs, lesdits motifs ayant la forme de pyramides à base carrée,
- l'aspect antireflet.

A titre d'exemples de matières plastiques, on peut citer le poly(méthacrylate de méthyle (PMMA), polyvinylbutyral (PVB), polycarbonate (PC) ou polyuréthane (PU), copolymère éthylène/acétate de vinyle (EVA) thermoplastique, poly(téréphtalate d'éthylène) (PET), poly(téréphtalate de butylène) (PBT), copolymères polycarbonates/polyester, copolymère cyclooléfinique du type éthylène/norbornène ou éthylène/cyclopentadiène, les résines ionomères, par exemple un copolymère éthylène/acide (méth)acrylique neutralisé par une polyamine, les thermodurcissables ou thermoréticulables tels que polyuréthane, polyester insaturé (UPE), copolymère éthylène/acétate de vinyle ...) ou d'une combinaison de plusieurs de ces matériaux.

Le substrat est constitué, de préférence, d'un matériau verrier ou d'une matière plastique du type cité précédemment. Il peut consister en une feuille unique, un feuilleté formé de plusieurs feuilles assemblées ou bien être un objet massif dont la surface destinée à recevoir la couche est lisse, en général, mais non nécessairement plane. Le substrat peut être un intercalaire de feuilletage.

Le substrat peut être un vitrage en verre silicosodocalcique, notamment extraclair, et le substrat revêtu peut présenter :

- une transmission du rayonnement lumineux supérieure ou égale à 91% voire supérieure ou égale 92% ou même 93% ou 94% à 600 nm et/ou à 550 nm ou de préférence sur toute la gamme visible, soit typiquement une augmentation d'au moins 2% voire 3% ou 4% de la transmission du rayonnement lumineux du substrat transparent porteur,
- et/ou une réflexion du rayonnement lumineux inférieure ou égale à 7%, voire inférieure ou égale à 4%, à 600 nm et/ou à 550 nm ou de préférence sur toute la gamme visible.

Les applications notamment antireflets du substrat revêtu de la couche poreuse sont diverses :

- comme vitrage utilitaire type verre d'aquarium, de vitrine, de serre, de comptoir, de vitrage de protection d'un tableau,
- pour le mobilier urbain (panneau d'affichage, abri de bus...) ou l'aménagement intérieur (panneau décoratif) ou l'ameublement (façade de meuble ...),
- pour un véhicule de transport aéronautique, maritime, terrestre (ferroviaire, routier), du type pare-brise, lunette arrière, toit auto, vitre latérale,
- pour le bâtiment (fenêtre, porte-fenêtre),
- pour l'électroménager (porte de réfrigérateur, de four, vitrine de meuble, plaque vitrocéramique).

En applications notamment intérieures, on peut encore citer des vitrages destinés à protéger des tableaux, à faire des vitrines de musées, présentoirs, des cloisons intérieures (hôpitaux, salles blanches, de contrôle), des studios de télévision et d'enregistrement, des cabines de traduction. En applications extérieures, on peut encore citer les vitrines de magasins, baies vitrées de restaurant, tours de contrôle (aéroports ports), vitrages extérieurs de séparation (des spectateurs dans les stades ...). On peut aussi citer, les panneaux signalétiques ou publicitaires (gares, aéroports etc), les cabines de commandes d'engins de chantiers (grues, tracteurs).

Les détails et caractéristiques avantageuses de l'invention vont maintenant ressortir des exemples suivants non limitatifs, à l'aide des figures :

- les figures 1 à 4ter sont des images de microscopie électronique à balayage en coupe transverse ou en vue de dessus de couches poreuses conformément à un mode de réalisation de l'invention,
- les figures 5 à 7 illustrent des graphes représentant les spectres en transmission de différents substrats nus ou revêtus de la couche poreuse selon les différents exemples de l'invention ou selon des exemples comparatifs,
- les figures 8 à 10 illustrent trois modules solaires intégrant un substrat revêtu d'une couche poreuse, modules qui ne font pas partie de l'invention
- la figure 11 illustre un vitrage feuilleté teinté lumineux intégrant un substrat revêtu d'une couche poreuse selon un mode de réalisation de l'invention,
- la figure 12 illustre le facteur de transmission en fonction de l'angle d'un dispositif électroluminescent organique qui ne fait pas partie de l'invention dont le substrat est nu ou revêtu sur sa face externe d'une couche poreuse selon un mode de réalisation de l'invention.

EXEMPLES DE FABRICATION

• SERIE N°1

On découpe des échantillons de 10 cm x 10 cm d'un verre float verre clair silico-sodocalcique extraclair de 2,1 mm d'épaisseur, tel que le verre DIAMANT commercialisé par SAINT-GOBAIN GLASS. Ces échantillons sont lavés avec une solution de RBS, rincés, séchés et soumis à un traitement UV ozone pendant 45 min.

Chacun de ces échantillons est destiné à recevoir une couche poreuse selon l'invention sur la face étain ou sur la face bain. Le verre float peut être muni d'une sous-couche barrière aux alcalins par exemple type $SiO_2$, SiOC, SiNx, d'épaisseurs de l'ordre de 50 à 100 nm en ajustant éventuellement le choix des épaisseurs et des indices.

Le procédé de formation de la couche poreuse est décrit ci après.

La première étape de ce procédé consiste à préparer la composition liquide de traitement appelée par la suite « sol ».

Le sol est obtenu en mélangeant 20,8 g de tétraéthylorthosilicate, 18,4 g d'éthanol absolu, 7,2 g d'une solution aqueuse de pH = 2,5 acidifiée à l'aide de HCl. Le rapport molaire correspondant est 1 :4 :4. Cette composition est mélangée de préférence pendant quatre heures afin d'obtenir une hydrolyse complète du précurseur alkoxyde.

La deuxième étape de ce procédé consiste à mélanger au sol de silice obtenu précédemment l'agent porogène, à savoir des billes polymériques submicroniques, en proportions diverses et de différentes natures suivant les échantillons.

Dans une première configuration (essais 1 à 4), on incorpore des billes de PMMA dispersées dans de l'éthanol (20 % en poids). Différentes quantités de billes sont ajoutées pour obtenir une large gamme d'indices de réfraction. Un taux donné d'éthanol est privilégié en fonction de l'épaisseur de couches souhaitée. Ces billes ont un diamètre moyen total de 80 nm $\pm$ 10 nm mesurés par diffusion dynamique de la lumière (« Dynamic Light Scattering » en anglais) avec l'appareil Malvern Nano ZS.

Dans une deuxième configuration (essais 5 à 6), on incorpore le sol de silice dans une dispersion polymérique comportant des billes de copolymère méthyl méthacrylate/acide acrylique dispersées dans de l'eau (16% en poids, à pH = 4). Ces billes ont un diamètre moyen total de 75 nm $\pm$ 30 nm mesurés par diffusion dynamique de la lumière avec l'appareil Malvern Nano ZS.

La troisième étape est le dépôt du mélange de préférence préalablement filtré à 0,45 $\mu$m. Le dépôt se fait par spin coating sur une première face du verre, côté étain ou bain. La vitesse de rotation est par exemple égale à 1000 tours par minute.

D'autres techniques de dépôt équivalentes sont le dip coating, la pulvérisation, l'enduction laminaire, le roll coating, le flow coating.

La quatrième étape correspond à un traitement thermique.

Ainsi, une première partie des échantillons 1 à 6 est chauffée à 450°C pendant 3 heures pour éliminer les billes et densifier la couche et éliminer le ou les solvants. De préférence, on peut prévoir après le dépôt du sol une étape préalable d'élimination des solvants à 100°C pendant 1 heure par exemple pour réduire le risque d'apparition de craquelures suite à un chauffage trop brutal.

Une deuxième partie des échantillons 1 à 6 sont soumis au traitement de trempe à 640°C pendant 10 minutes permettant d'éliminer les billes et densifier la couche et d'obtenir un verre trempé. De préférence on peut prévoir après le dépôt du sol une étape préalable d'élimination des solvants à 100°C pendant 1 heure par exemple pour réduire le risque d'apparition de craquelures suite à un chauffage trop brutal.

Une cinquième étape facultative consiste à rajouter une surcouche. Ainsi une partie des échantillons 1 à 6 est fonctionnalisée avec du perfluorosilane $CF_3$-$(CF_2)_7$-$CH_2$-$CH_2$-Si-$(OH)_3$ - selon la procédure Aquacontrol® décrite dans la demande de brevet EP799873 - pour renforcer encore la tenue hydrolytique, en particulier en vue d'applications en extérieur ou en atmosphère humide.

Dans le cas d'un substrat plastique, seule la quatrième étape est modifiée : on élimine les billes par un solvant ad hoc, il reste nécessaire de faire un traitement thermique à 80°C pour densifier la couche et/ou un traitement UV.

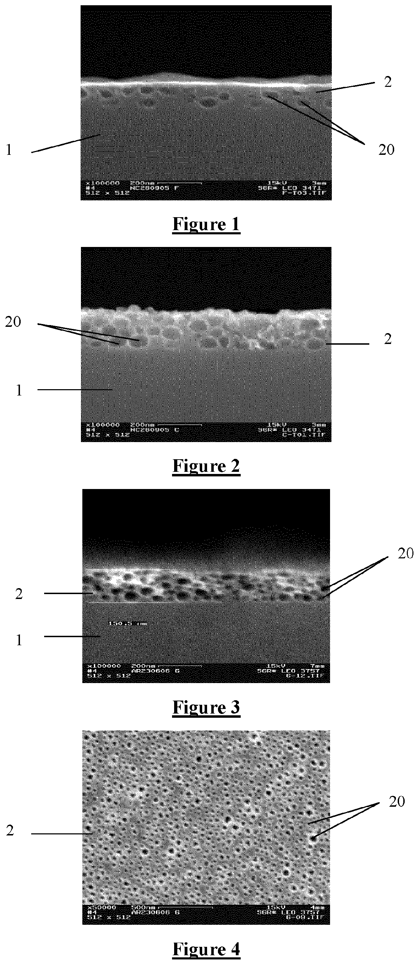

Les figures 1 et 2 montrent des images de microscopie électronique à balayage en coupe transverse plane des échantillons 2 et 3.

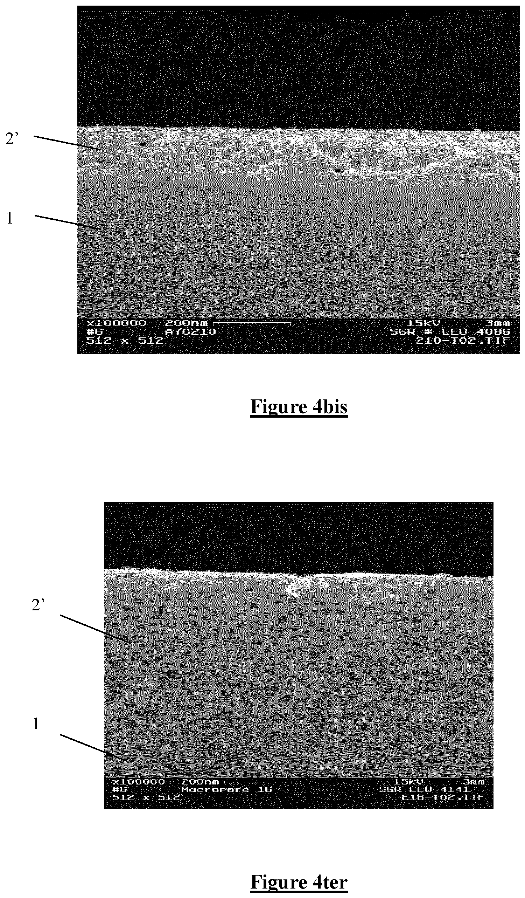

Les figures 3 et 4 montrent respectivement des images de microscopie électronique à balayage en coupe transverse plane et en vue de dessous de l'échantillon 5.

Pour tous les échantillons, on constate que la couche poreuse 2 présente des pores 20 bien individualisés et répartis de façon homogène dans toute son épaisseur, depuis l'interface avec le substrat en verre 1 jusqu'à l'interface avec l'air.

La surface de la couche poreuse 2 est remarquablement lisse du fait de l'élimination des billes polymériques sans création de fissures. Le flou est inférieur à 0,5%.

En utilisant les billes de PMMA, les pores de la couche poreuse ont une taille entre 50 et 70 nm, ce qui est proche de la taille de ces billes.

En utilisant les billes de copolymères de méthyl méthacrylate/acide acrylique, les pores de la couche poreuse ont une taille entre 30 et 70 nm reproduisant sensiblement la dispersion en taille de ces billes.

On consigne dans le tableau 1 ci-après différentes caractéristiques des couches des essais 1 à 6.

Tableau 1

| Essais N° | Volume de sol (μl) | Volume de solution à billes (μl) | % volume des billes | solvant (μl) | e (nm) |
|---|---|---|---|---|---|
| 1 | 200 | 260 | 55,6 | 2500 | 100 |
| 2 | 400 | 160 | 33,3 | 2500 | 130 |
| 3 | 200 | 360 | 68,9 | 2500 | 150 |
| 4 | 1000 | 600 | 55,6 | 400 | 800 |
| 5 | 600 | 260 | 62,2 | 2500 | 150 |
| 6 | 600 | 75 | 42,2 | 2500 | 120 |

Les épaisseurs des couches sont mesurées à partir des clichés MEB.

On pourrait choisir un autre précurseur notamment un silicate de sodium, de lithium ou de potassium, de 5 à 30% en solution dans l'eau.

Ainsi, en variante, dans le cas d'un substrat plastique ou verre, on choisit comme liant un silicate de potassium de sodium ou de lithium, on élimine les billes soit par un solvant ad hoc extracteur du polymère, par exemple un THF dans le cas du PMMA suivi d'un séchage à 80°C par exemple par infrarouge sous air pulsé, soit par un traitement thermique à partir de 350°C pendant au moins une heure pour éliminer les billes.

• SERIE N°2

Des échantillons de verre DIAMANT sont préparés comme dans la série n°1.

Un sol de silice est élaboré par hydrolyse de tétraéthylorthosilicate (TEOS) dans de l'eau acidifiée avec de l'acide chlorhydrique à pH = 2,5. La concentration massique de TEOS dans la formulation est de 40%. Le sol est hydrolysé sous agitation vigoureuse pendant 90 minutes (la solution initialement trouble devient limpide).

L'agent porogène solide utilisé est une des billes acryliques en suspension dans l'eau (extrait sec de 40%, pH = 5). Ces billes ont un diamètre moyen total de 70 nm ± 20 nm mesuré par diffusion dynamique de la lumière avec l'appareil Malvern Nano ZS.

Après incorporation de l'agent porogène, la formulation est diluée avec de l'eau acidifiée avec de l'acide chlorhydrique (pH = 2,5) pour ajuster l'épaisseur.

Dans un autre mode de réalisation, un précurseur d'alumine est ajouté à la formulation dans le but de doper la silice. Ce précurseur est l'acétylacétonate d'aluminium ou Al(acac). Il est introduit à raison de 5% molaire en remplacement du silicium. Pratiquement, l'Al(acac) est dissout dans l'eau de dilution avant ajout dans le sol. L'agent porogène est ajouté en dernier dans la formulation.

Les différentes formulations sont déposées par spin-coating à 2000 tours/min. Les échantillons sont ensuite directement traités thermiquement pendant 3 min à 700°C.

Les détails des différents essais sont donnés dans le tableau 2.

Tableau 2

| Essais N° | Volume de sol (µl) | Volume de solution à billes (µl) | % volume des billes | Masse d'Al(acac) (mg) | solvant (µl) |
|---|---|---|---|---|---|
| 7 | 3230 | 570 | 55% | 0 | 6200 |
| 8 | 3090 | 570 | 55% | 31 | 6340 |

Les couches ont une épaisseur de 110 nm environ, et des pores d'environ 70 nm (observations au MEB).

• SERIE N°3

Dans cette troisième série, seul l'agent porogène est différent de celui de la série n°2. Il s'agit d'une nanoémulsion d'huile paraffine dans l'eau (16.5% massique). La taille des gouttes d'huile est de 32 nm ± 10 nm mesurée par diffusion dynamique de la lumière avec l'appareil Malvern Nano ZS.
On utilise un sol de silice formulé dans l'eau pour éviter de déstabiliser l'émulsion.
Comme dans les exemples 6 et 7, il est possible de doper la silice avec de l'alumine.
Les couches sont déposées puis traitées thermiquement dans les mêmes conditions que la série n°2.
Les détails des différents essais sont donnés dans le tableau 3.

Tableau 3

| Essais N° | Volume de sol (µl) | Volume de solution à nanogouttes (µl) | % volume des nanogouttes | Masse d'Al(acac) (mg) | solvant (µl) |
|---|---|---|---|---|---|
| 9 | 3230 | 1380 | 55% | 0 | 5390 |
| 10 | 3090 | 1380 | 55% | 31 | 5530 |

Les couches ont une épaisseur de 110 nm environ et des pores de 30 nm (observations au MEB).
Les figures 4bis et 4ter montrent respectivement des images de microscopie électronique à balayage en coupe transverse plane du type de la série n°3.
Pour la figure 4bis, il s'agit d'une couche poreuse mince 2' sur verre 1 et pour la figure 4ter, d'une couche poreuse épaisse 2' sur verre 1.

PROPRIETES OPTIQUES

On consigne dans le tableau 4 ci-après l'indice de réfraction dans le visible des couches 1 à 10.

Tableau 4

| Essais N° | e (nm) | n |
|---|---|---|
| 1 | 100 | 1,2 |
| 2 | 130 | 1,3 |
| 3 | 150 | 1,14 |
| 4 | 800 | 1,2 |
| 5 | 150 | 1,17 |
| 6 | 120 | 1,26 |
| 7 | 110 | 1,25 |
| 8 | 120 | 1,27 |
| 9 | 100 | 1,27 |
| 10 | 110 | 1,30 |

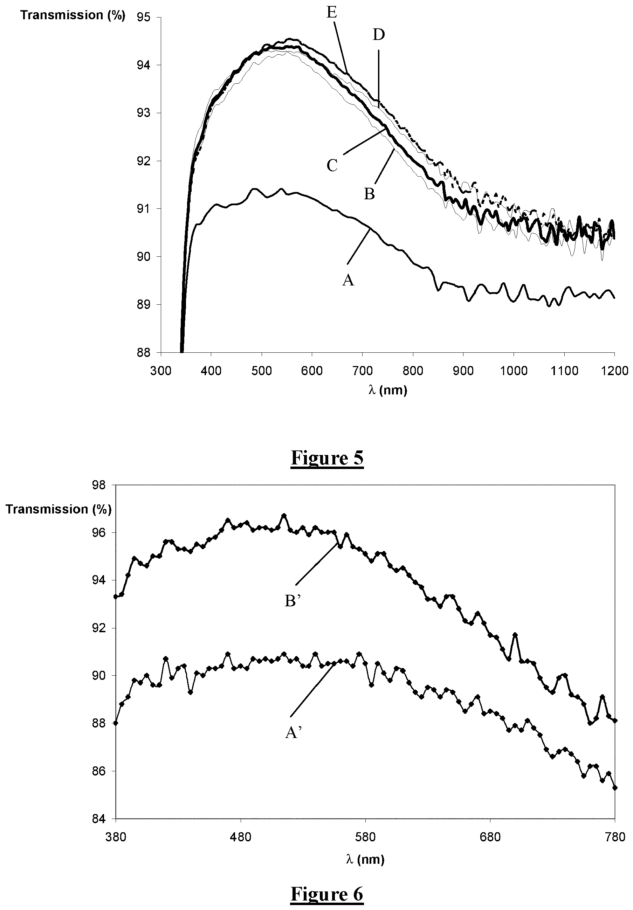

La figure 5 montre les profils de transmission T entre 400 et 1200 nm pour un verre extraclair type diamant nu (courbe A), et pour des échantillons de l'essai n°1:

- un premier traité thermiquement à 450°C sans greffage fluorosilane (courbe B),
- un deuxième traité thermiquement à 640°C et greffé fluorosilane (courbe C),
- un troisième traité thermiquement à 640°C sans greffage fluorosilane (courbe D),
- un quatrième non traité thermiquement à 640°C et greffé fluorosilane (courbe E).

On observe pour les échantillons de l'essai n°1 une augmentation de 3 ou 4% de la transmission lumineuse dans le visible et de 2% dans les proches infrarouges par rapport au verre nu comparatif. Ni le greffage ni le traitement à 640°C n'affecte les propriétés optiques.

Dans toute la gamme 400 - 1200 nm, la transmission T est supérieure à 90%, notamment supérieure ou égale à 93% entre 400 et 700 nm.

La réflexion R est par ailleurs sensiblement constante, autour de 5 à 5,5% entre 400 et 700 nm et autour de 8% entre 700 et 1200 nm.

On obtient des résultats similaires avec les échantillons des essais n°2 à 10.

En variante, on a déposé des couches selon les procédés précédemment décrits pour les séries n°1 à n°3 en remplaçant le verre extraclair DIAMANT par un verre clair de type PLANILUX de 2,1 mm d'épaisseur.

La figure 6 montre ainsi les profils de transmission T entre 300 et 1200 nm pour un verre Planilux nu (courbe A'), et pour un deuxième échantillon avec une couche poreuse sur chaque face (courbe B'), chaque couche étant traitée à 450°C.

Cet échantillon est pour une application antireflet classique qui ne fait pas partie de l'invention: des vitrines de magasins, des vitrages à protéger, des tableaux, des comptoirs.

On observe une augmentation de 5 à 6% de la transmission T dans le visible pour l'échantillon « bicouche » avec une transmission de 96% à 550 nm. La réflexion R est par ailleurs sensiblement constante, autour de 2 - 2,5%, entre 400 et 700 nm, notamment 1,9 à 550 nm, contre environ 5% avec une seule couche.

TESTS

Les échantillons 1 à 6 subissent différents tests détaillés comme suit.

Un premier test consistant à évaluer la durabilité, est souvent dénommé en anglais « climate test » selon la norme IEC61250. Les couches subissent 20 cycles thermiques de - 40°C à + 80°C.

Comme deuxième test, ces couches subissent un test de résistance à l'humidité connu sous le terme anglais de « damp heat », et consistant à les laisser pendant 1000 heures à 85°C dans une enceinte dont l'atmosphère a un taux d'humidité relative contrôlé de 85 % (norme IEC 61215).

Comme troisième test, on fait subir à ces couches le test de résistance chimique basique connu sous le terme de test de brouillard salin neutre ou BSN, selon la norme DIN 50021. Le protocole est le suivant : les couches sont soumises à un brouillard aqueux contenant 50 g/l de NaCl avec un pH de 7 et une température de 35°C pendant 500 heures.

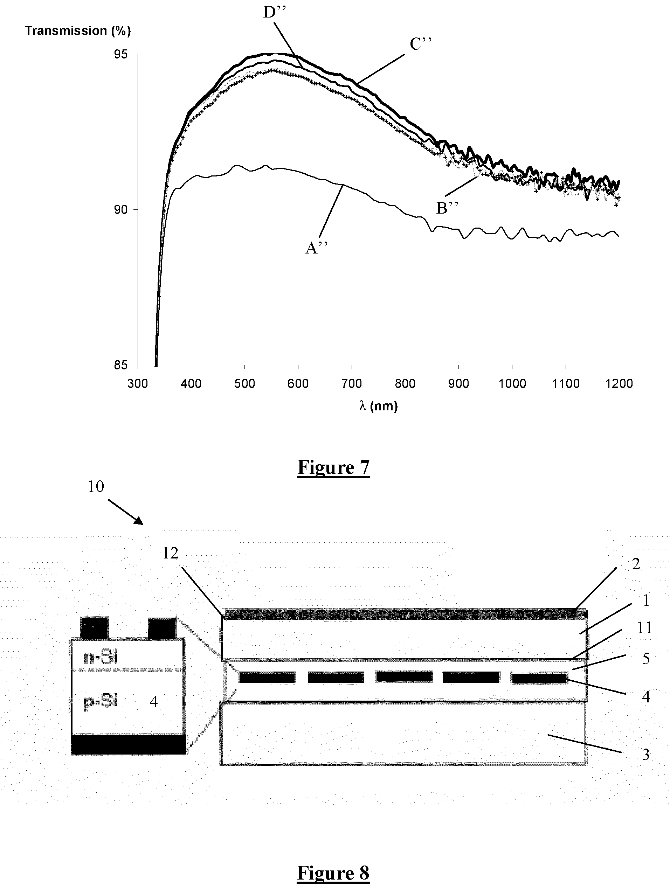

La figure 7 montre ainsi les profils de transmission lumineuse entre 300 et 1200 nm pour un verre DIAMANT nu (courbe A") et pour des échantillons de la série 1 suivants :

- échantillon traité thermiquement à 640°C avec ou sans greffage n'ayant subi aucun test (courbe B"),
- échantillon traité thermiquement à 640°C avec ou sans greffage et ayant subi le premier test (courbe C"),
- échantillon traité thermiquement à 640°C avec ou sans greffage et ayant subi le deuxième test (courbe D"),
- échantillon traité thermiquement à 640°C et ayant subi le troisième test (courbe E").

On observe que la transmission lumineuse est inchangée tout comme la réflexion lumineuse et l'indice de réfraction.

Les échantillons 7 à 10 subissent les tests suivants :

- le test damp heat défini ci-dessus,
- un test de résistance à l'abrasion (Opel) selon la norme DIN 61200.

Les procédés décrits ci-dessus peuvent aussi être modifiés comme suit.

On pourrait aussi incorporer d'autres agents porogènes connus avec les billes, par exemple des micelles de molécules tensioactives cationiques en solution et, éventuellement, sous forme hydrolysée, ou de tensioactifs anioniques, non ioniques, ou des molécules amphiphiles, par exemple des copolymères blocs. De tels agents génèrent des pores sous forme de canaux de petite largeur ou des pores plus ou moins ronds de petite taille entre 2 et 5 nm. Le tensioactif cationique peut être le bromure de cétyltriméthylammonium, le précurseur du matériau est en solution sous sa forme résultant d'une hydrolyse en milieu acide:$Si(OH)_4$ et le rapport molaire tensioactif:Si est compris entre $10^{-4}$ et 0,5.

En variante, on peut choisir de revêtir la couche poreuse d'une face texturée avec un relief macroscopique, notamment un verre extraclair laminé et imprimé tel que le verre ALBARINO de la société SAINT GOBAIN GLASS ou encore un verre clair type PLANILUX de la société SAINT GOBAIN GLASS.

En autre variante, on peut aussi prévoir un empilement de couches poreuses de préférence de plus en plus poreuses avec l'épaisseur croissante.

MODULE SOLAIRE (HORS INVENTION)

On choisit préférentiellement les échantillons 1, 6 et 10 en tant que verre extérieur d'un module solaire qui ne fait pas partie de l'invention.

Le module 10 montré en figure 8 est constitué de la façon suivante : le verre 1 muni de la couche poreuse antireflet 2 sur sa face extérieure 12 (côté air) est associé par sa face intérieure 11 à un verre 3 dit verre « intérieur ». Ce verre intérieur 3 est en verre trempé, de 2,1 mm d'épaisseur, et clair ou extra-clair.

Plus précisément, les cellules photovoltaïques 4 sont placées entre les deux verres 1, 3 puis on vient couler dans l'entre-verre un polymère durcissable à base de polyuréthane 5 conformément à l'enseignement du brevet EP 0 739 042.

Chaque cellule photovoltaïque 4 est constituée, de façon connue, à partir de « wafers » de silicium formant une jonction p/n et des contacts électriques avant et arrière imprimés. Les cellules photovoltaïques de silicium peuvent être remplacées par des cellules solaires utilisant d'autres semiconducteurs (comme CIS, CdTe, a-Si, GaAs, GaInP).

A titre de comparaison, on a monté un module solaire identique au précédent, mais avec un verre extérieur en verre extra-clair ne comportant pas la couche poreuse antireflet selon l'invention.

L'augmentation du rendement, exprimée en densité de courant intégrée, est d'environ 2,9% par rapport au module classique.

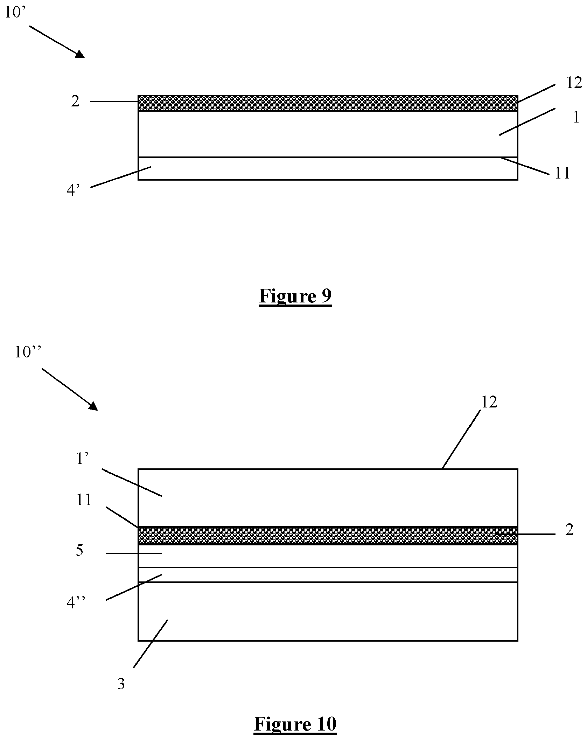

Dans une première variante montrée en figure 9, le module 10' comprend le verre 1 avec sur sa face extérieure 12 la couche poreuse 2 et sur sa face intérieure une ou des cellules photovoltaïques 4' à couche mince par exemple de type a-Si,CdTe, GaAs ou GaInP.

Plus précisément, et de façon conventionnelle, chaque cellule photovoltaïque comprend l'empilement suivant :

- une couche transparente électroconductrice (connue sous le nom de « TCO » en anglais),
- la couche active type a-Si (mono ou multicouche),
- un réflecteur métallique par exemple en argent ou aluminium.

Dans une deuxième variante montrée en figure 10, les cellules photovoltaïques 4", sont de type CIS et sur du verre 3.

Les cellules photovoltaïques 4" sont feuilletées avec un intercalaire de feuilletage 5, par exemple en EVA au premier verre 1'. Comme premier verre 1, on choisit de préférence un verre coloré 1' avec sur sa face interne de feuilletage 11 la couche poreuse bas indice 2 de préférence des échantillons 3, 4 ou 5, avec un indice le plus bas possible et une épaisseur à partir de 150 nm.

Ce type de module par exemple sur une façade conserve la couleur du verre coloré.

Eventuellement, une couche antireflet externe notamment telle que la couche poreuse des échantillons 1, 6 à 10 peut être rajoutée.

En variante, on forme un simple vitrage feuilleté, la couche poreuse formant un séparateur optique.

STRUCTURE FEUILLETEE LUMINEUSE

On réalise un toit lumineux 100 pour automobile comprenant :

- un premier substrat transparent et plan 1, d'indice optique n1 égal à 1,5 environ, par exemple un verre clair ou extraclair,
- un deuxième substrat plan teinté dans la masse 1", notamment un verre teinté, tel que le verre VG10,
- un intercalaire de feuilletage 5, entre les premier et deuxième substrats, par exemple un PVB,
- une couche poreuse 2" discontinue formant séparateur optique, déposée sur le premier verre, la couche 2" étant d'indice optique n2 par exemple égale à 1,1 et d'épaisseur 400 nm,
- une source d'éclairage par la tranche du premier substrat, sous forme de diodes électroluminescentes 6 de préférence logées dans une rainure du premier verre 1,
- un réseau rétrodiffusant interne 7 entre la couche poreuse et le premier substrat, sous forme de motifs de dimensions adaptées en fonction de l'éclairage souhaité.

Pour la couche poreuse on peut choisir l'une des couches des exemples précités en ajustant l'épaisseur si nécessaire.

DISPOSITIF « OLED » (HORS INVENTION)

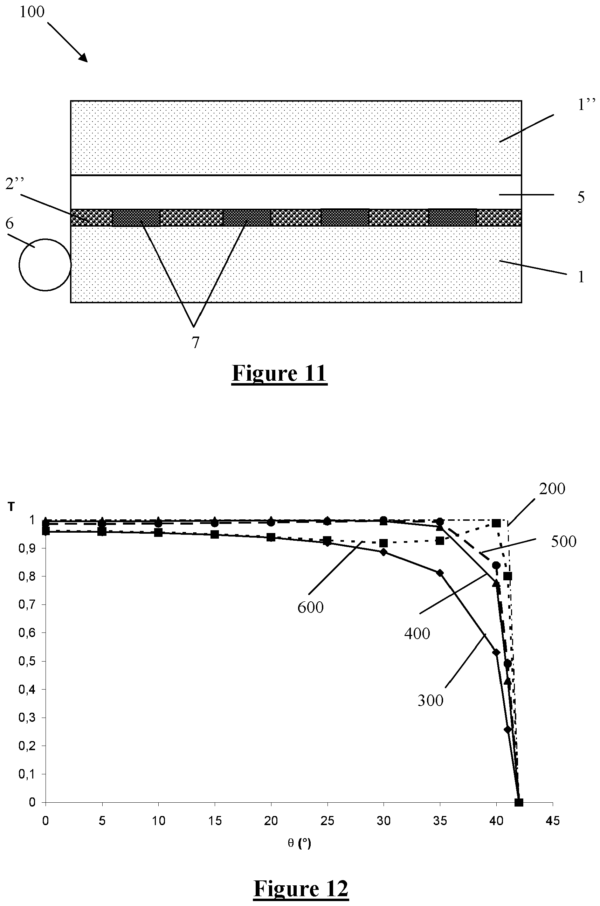

La figure 12 illustre le facteur de transmission en fonction l'angle d'un dispositif électroluminescent organique qui ne fait pas partie de l'invention intégrant un substrat nu ou revêtu sur sa face externe d'une couche poreuse obtenue avec un agent porogène de type nanoparticules ou nanogouttes, par exemple par les procédés de fabrications déjà décrits pour les exemples 1 à 10.

Le profil de la courbe 200 correspond au cas idéal où l'ensemble des faisceaux lumineux, quelle que soit leur incidence à l'interface entre le verre et l'air, est extrait du verre.

La courbe 300 correspond à un verre nu.

La courbe 400 correspond à un verre revêtu de la couche poreuse pour une optimisation de l'extraction réalisée à 0°.

La courbe 500 correspond à un verre revêtu de la couche poreuse pour une optimisation de l'extraction réalisée à 32°.

La courbe 600 correspond à un verre revêtu de la couche poreuse pour une optimisation de l'extraction réalisée à 40°.

Par ailleurs, le rapport de forme normalisée A défini par la relation suivante :

$$A = \frac{\int T(\theta)\, d\theta}{\int R(\theta)\, d\theta},$$

dans laquelle

$T(\theta)$ correspond à la transmission de la lumière en fonction de l'angle d'incidence du faisceau lumineux $\theta$,
$R(\theta)$ est un profil rectangulaire en fonction de l'angle d'incidence du faisceau lumineux $\theta$, compris entre 0° et l'angle limite de réfraction entre le verre et l'air, la hauteur de $R(x)$ étant normalisée à 1.

Le rapport de forme A évaluant donc l'écart à l'idéalité de la configuration, est reporté en tableau 6. Pour chaque optimisation d'extraction à un angle donné, on obtient un choix préféré d'indice optique et d'épaisseur.

Tableau 6

| Angle d'optimisation | n | e(nm) | Rapport de forme A |
|---|---|---|---|
| Verre nu (comparatif) | | | 0,875 |
| 0° (verre revêtu) | 1,22 | 135 | 0,965 |
| 32° (verre revêtu) | 1,19 | 160 | 0,968 |
| 40° (verre revêtu) | 1,1 | 280 | 0,941 |

On observe une augmentation notable du rapport de forme avec la couche poreuse.

## Revendications

**1.** Structure feuilletée lumineuse (100) **caractérisée en ce qu'**elle comporte :

- un premier substrat transparent et plan (1), d'indice optique n1 donné,
- un deuxième substrat plan teinté dans la masse (1"),
- un intercalaire de feuilletage (5), entre les premier et deuxième substrats,
- une couche poreuse (2") formant séparateur optique, déposée sur l'intercalaire de feuilletage ou sur le premier substrat, la couche étant d'indice optique n2, l'écart n1 - n2 étant supérieur ou égal à 0,1,

- une source lumineuse (6) couplée à la tranche du premier substrat,
- un réseau rétrodiffusant interne (7) entre la couche poreuse et le premier substrat, et/ou un réseau diffusant externe sur la face externe du premier substrat.

**2.** Structure feuilletée lumineuse (100) selon la revendication précédente **caractérisée en ce que** le premier substrat transparent et plan est un verre clair ou extraclair.

**3.** Structure feuilletée lumineuse (100) selon l'une quelconque des revendications précédentes **caractérisé en ce que** le deuxième substrat plan teinté dans la masse (1") est un verre teinté.

**4.** Structure feuilletée lumineuse (100) selon l'une quelconque des revendications précédentes **caractérisée en ce que** la source lumineuse (6) couplée à la tranche du premier substrat, est des diodes électroluminescentes.

**5.** Structure feuilletée lumineuse (100) selon l'une quelconque des revendications précédentes **caractérisée en ce que** l'écart n1 - n2 est supérieur ou égal à 0,2 et de préférence dans toute la gamme du visible.

**6.** Structure feuilletée lumineuse (100) selon l'une quelconque des revendications précédentes **caractérisée en ce que** l'épaisseur de la couche poreuse est supérieure ou égale 200 nm, voire 400 nm et de préférence inférieure à 1 $\mu$m.

**7.** Structure feuilletée lumineuse (100) selon l'une quelconque des revendications précédentes **caractérisée en ce que**, en cas de réseau rétrodiffusant interne, la couche poreuse est déposée uniquement entre le réseau interne ou bien recouvre également le réseau interne, de préférence de facteur de réflexion diffuse supérieur ou égal à 50%, voire à 80% et/ou le réseau externe diffusant, servant pour extraire la lumière, a un facteur de transmission diffuse supérieur ou égal à 50%, voire à 80%.

**8.** Structure feuilletée lumineuse (100) selon l'une quelconque des revendications précédentes **caractérisée en ce que** le réseau diffusant ou rétrodiffusant est essentiellement minéral, à base de liant minéral et/ou de particules diffusantes minérales.

**9.** Structure feuilletée lumineuse (100) selon l'une quelconque des revendications précédentes **caractérisée en ce que** la couche poreuse est de type sol gel ou avec des pores qui sont les interstices d'un empilement non compact des billes nanométriques, notamment de silice.

**10.** Structure feuilletée lumineuse (100) selon l'une quelconque des revendications précédentes **caractérisée en ce que** la couche poreuse (2, 2') est essentiellement minérale et de type sol-gel présentant une série de pores (20) fermés avec au moins la plus petite dimension caractéristique qui est, en moyenne, supérieure ou égale à 20 nm et de préférence inférieure ou égale à 100 nm.

**11.** Structure feuilletée lumineuse (100) selon la revendication 10 **caractérisée en ce que** les pores ont une forme définie, de préférence sensiblement sphérique ou ovale.

**12.** Structure feuilletée lumineuse (100) selon l'une des revendications 10 à 11 **caractérisé en ce que** la couche poreuse (2, 2') est essentiellement à base de silice, hybride ou minérale, de préférence dopée par l'un au moins des dopants suivants : Al, Zr, B, Sn, Zn.

**13.** Structure feuilletée lumineuse (100) selon l'une des revendications 10 à 12 **caractérisé en ce que** la couche poreuse (2, 2') présente un indice de réfraction à 600 nm ou à 550 nm au moins inférieur de 0,1 à l'indice de réfraction d'une couche minérale de matière minérale identique dense, de préférence un indice de réfraction à 600 nm ou à 550 nm qui est inférieur ou égal à 1,3 voire à 1,1.

**14.** Structure feuilletée lumineuse (100) selon l'une des revendications 10 à 13 **caractérisé en ce que** le premier substrat est un vitrage (1, 1'), et le vitrage revêtu de la couche poreuse a été traité thermiquement, à une température supérieure ou égale à 450°C de préférence supérieure ou égale à 600°C, notamment est un verre trempé.

**15.** Structure feuilletée lumineuse (100) selon l'une quelconque des revendications précédentes **caractérisée en ce qu'**elle forme un toit lumineux d'un véhicule, un double vitrage lumineux pour le bâtiment, l'extérieur ou l'intérieur tels que façades, cloisons, portes, fenêtres, table ou étagère.

**Patentansprüche**

1. Laminierte Beleuchtungsstruktur (100), **dadurch gekennzeichnet, dass** sie umfasst:

   - ein erstes transparentes und flaches Substrat (1) mit gegebener optischer Dichte n1,
   - ein zweites flaches durchgefärbtes Substrat (1"),
   - eine Laminierungszwischenlage (5) zwischen dem ersten und zweiten Substrat,
   - eine einen optischen Verteiler bildende poröse Schicht (2"), die auf der Laminierungszwischenlage oder auf dem ersten Substrat aufgebracht ist, wobei die Schicht die optische Dichte n2 hat, wobei die Differenz n1 - n2 mindestens 0,1 beträgt,
   - eine Lichtquelle (6), die an die Kante des ersten Substrats gekoppelt ist,
   - ein rückstreuendes inneres Gitter (7) zwischen der porösen Schicht und dem ersten Substrat und/oder ein streuendes äußeres Gitter auf der Außenseite des ersten Substrats.

2. Laminierte Beleuchtungsstruktur (100) nach dem vorhergehenden Anspruch, **dadurch gekennzeichnet, dass** das erste transparente und flache Substrat ein klares oder extraklares Glas ist.

3. Laminierte Beleuchtungsstruktur (100) nach einem der vorhergehenden Ansprüche, **dadurch gekennzeichnet, dass** das zweite flache durchgefärbte Substrat (1") ein gefärbtes Glas ist.

4. Laminierte Beleuchtungsstruktur (100) nach einem der vorhergehenden Ansprüche, **dadurch gekennzeichnet, dass** die Lichtquelle (6), die an die Kante des ersten Substrats gekoppelt ist, Leuchtdioden sind.

5. Laminierte Beleuchtungsstruktur (100) nach einem der vorhergehenden Ansprüche, **dadurch gekennzeichnet, dass** die Differenz n1 - n2 mindestens 0,2 beträgt und bevorzugt im gesamten sichtbaren Bereich.

6. Laminierte Beleuchtungsstruktur (100) nach einem der vorhergehenden Ansprüche, **dadurch gekennzeichnet, dass** die Dicke der porösen Schicht mindestens 200 nm oder sogar 400 nm und bevorzugt weniger als 1 $\mu$m beträgt.

7. Laminierte Beleuchtungsstruktur (100) nach einem der vorhergehenden Ansprüche, **dadurch gekennzeichnet, dass**, im Fall eines rückstreuenden inneren Gitters, die poröse Schicht nur zwischen dem inneren Gitter aufgebracht ist oder aber auch das innere Gitter überdeckt, bevorzugt mit einem Grad der gestreuten Reflexion von mindestens 50 % oder sogar 80 %, und/oder das äußere streuende Gitter, das zum Auskoppeln des Lichts dient, einen Grad der gestreuten Transmission von mindestens 50 % oder sogar 80 % hat.

8. Laminierte Beleuchtungsstruktur (100) nach einem der vorhergehenden Ansprüche, **dadurch gekennzeichnet, dass** das streuende oder rückstreuende Gitter im Wesentlichen mineralisch ist, auf Basis eines mineralischen Bindemittels und/oder mineralischer streuender Partikeln.

9. Laminierte Beleuchtungsstruktur (100) nach einem der vorhergehenden Ansprüche, **dadurch gekennzeichnet, dass** die poröse Schicht vom Typ Sol-Gel ist oder mit Poren, welche die Zwischenräume einer nicht kompakten Schichtung nanometergroßer Kugeln, insbesondere von Siliciumdioxid, sind.

10. Laminierte Beleuchtungsstruktur (100) nach einem der vorhergehenden Ansprüche, **dadurch gekennzeichnet, dass** die poröse Schicht (2, 2') im Wesentlichen mineralisch und vom Sol-Gel-Typ ist, aufweisend eine Reihe von geschlossenen Poren (20), deren kleinste charakteristische Größe durchschnittlich mindestens 20 nm und bevorzugt höchstens 100 nm beträgt.

11. Laminierte Beleuchtungsstruktur (100) nach Anspruch 10, **dadurch gekennzeichnet, dass** die Poren eine bestimmte, bevorzugt im Wesentlichen kugelige oder ovale Form haben.

12. Laminierte Beleuchtungsstruktur (100) nach einem der Ansprüche 10 bis 11, **dadurch gekennzeichnet, dass** die poröse Schicht (2, 2') im Wesentlichen auf Basis von Siliciumdioxid, hybrid oder mineralisch, ist, das bevorzugt mit mindestens einem der folgenden Dotierungsmittel dotiert ist: Al, Zr, B, Sn, Zn.

13. Laminierte Beleuchtungsstruktur (100) nach einem der Ansprüche 10 bis 12, **dadurch gekennzeichnet, dass** die poröse Schicht (2, 2') einen Brechungsindex bei 600 nm oder bei 550 nm aufweist, der um mindestens 0,1 kleiner als der Brechungsindex einer mineralischen Schicht aus identischem dichtem mineralischem Material ist, bevorzugt einen Brechungsindex bei 600 nm oder bei 550 nm, der höchstens 1,3 oder sogar 1,1 beträgt.

**14.** Laminierte Beleuchtungsstruktur (100) nach einem der Ansprüche 10 bis 13, **dadurch gekennzeichnet, dass** das erste Substrat eine Verglasung (1, 1') ist und die mit der porösen Schicht überzogene Verglasung bei einer Temperatur von mindestens 450 °C, bevorzugt mindestens 600 °C wärmebehandelt wurde, insbesondere ein vorgespanntes Glas ist.

**15.** Laminierte Beleuchtungsstruktur (100) nach einem der vorhergehenden Ansprüche, **dadurch gekennzeichnet, dass** sie ein leuchtendes Dach eines Fahrzeugs, eine leuchtende Doppelverglasung für Gebäude, den Innen- oder Außenbereich wie Fassaden, Trennwände, Türen, Fenster, Tische oder Regale bildet.

**Claims**

**1.** A luminous laminated structure (100) **characterized in that** it comprises:

- a transparent first flat substrate (1), of given optical index $n_1$,
- a bulk-tinted second flat substrate (1")
- a lamination interlayer (5) between the first and second substrates;
- a porous coating (2") forming an optical separator, deposited on the lamination interlayer or on the first substrate, the coating being of optical index $n_2$, the difference $n_1 - n_2$ being equal to or greater than 0.1;
- a light source (6) coupled into the edge of the first substrate,
- an internal backscattering network (7) between the porous coating and the first substrate and/or an external scattering network on the external face of the first substrate.

**2.** A luminous laminated structure (100) as claimed in preceding claim **characterized in that** said transparent first flat substrate (1) is a clear or extra-clear glass.

**3.** A luminous laminated structure (100) as claimed in any one of the preceding claims **characterized in that** said bulk-tinted second flat substrate is a tinted glass.

**4.** A luminous laminated structure (100) as claimed in any one of the preceding claims **characterized in that** said light source (6) coupled into the edge of the first substrate, is light-emitting diodes.

**5.** A luminous laminated structure (100) as claimed in any one of the preceding claims **characterized in that** the difference $n_1 - n_2$ being equal to or greater than 0.2 and preferably over the entire visible range.

**6.** A luminous laminated structure (100) as claimed in any one of the preceding claims **characterized in that** the thickness of the porous coating is equal to or greater than 200 nm, or even 400 nm, but preferably less than 1 $\mu$m.

**7.** A luminous laminated structure (100) as claimed in any one of the preceding claims **characterized in that** in the case of said internal backscattering network, said porous coating is deposited only between the internal network or else also cover the internal network, preferably has a diffuse reflection factor equal to or greater than 50%, or even 80% and/or said external network is scattering, serves for extracting light, and preferably has a diffuse transmission factor equal to or greater than 50% or even 80%.

**8.** A luminous laminated structure (100) as claimed in any one of the preceding claims **characterized in that in that** said scattering or backscattering network is essentially mineral, based on a mineral binder and/or mineral scattering particles.

**9.** A luminous laminated structure (100) as claimed in any one of the preceding claims **characterized in that** the porous coating is sol gel type or the pores are the interstices of a non-compact stack of nanoscale beads, for example silica beads.

**10.** A luminous laminated structure (100) as claimed in any one of the preceding claims **characterized in that** the essentially mineral porous coating (2, 2') is of the sol-gel type and having a series of closed pores (20), at least the smallest characteristic dimension of which is, on average, at least 20 nm but preferably does not exceed 100 nm.

**11.** A luminous laminated structure (100) as claimed in claim 10 **characterized in that** the pores have a defined shape, preferably a substantially spherical or oval shape.

**12.** A luminous laminated structure (100) as claimed in either of the claim 10 or 11, **characterized in that** the porous coating (2, 2') is essentially based on hybrid or mineral silica, preferably doped with at least one of the following dopants: Al, Zr, B, Sn, Zn.

**13.** A luminous laminated structure (100) as claimed in either of the claims 10 to 12, **characterized in that** the porous coating (2, 2') has a refractive index at 600 nm or at 550 nm at least 0.1 less than the refractive index of a mineral coating of dense identical mineral material, preferably a refractive index at 600 nm or at 550 nm which does not exceed 1.3 or even 1.1.

**14.** A luminous laminated structure (100) as claimed in either of the claims 10 to 13, **characterized in that** the first substrate is a glazing pane (1, 1') and the coated glazing pane, coated with the porous coating, is heat-treated at a temperature of 450°C or higher, preferably 600°C or higher, and is in particular a toughened glass.

**15.** A luminous laminated structure (100) as claimed in any one of the preceding claims, **characterized in that** it forms a luminous roof of a vehicle, a luminous double-glazing unit for buildings, exterior or interior applications, such as curtain walling, partitions, doors, windows, tables or shelves.

**Figure 1**

**Figure 2**

**Figure 3**

**Figure 4**

**Figure 4bis**

**Figure 4ter**

**Figure 5**

**Figure 6**

Transmission (%)

**Figure 7**

**Figure 8**

10'

2

12

1

11

4'

**Figure 9**

10''

1'

11

5

4''

12

2

3

**Figure 10**

100

1''

2''

6

5

1

7

**Figure 11**

T

1

0,9

0,8

0,7

0,6

0,5

0,4

0,3

0,2

0,1

0

0    5    10    15    20    25    30    35    40    45

θ (°)

200

500

600

400

300

**Figure 12**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1329433 A
- FR 2809496
- US 20040258929 A
- WO 2005049757 A
- WO 0205683 A
- US 5368892 A

- US 5389427 A
- EP 692463 A
- EP 0484746 A
- WO 2003046617 A
- EP 799873 A
- EP 0739042 A